# EUROPÄISCHE PATENTSCHRIFT

(11) **EP 1 082 885 B1**
(45) Veröffentlichungstag und Bekanntmachung des Hinweises auf die Patenterteilung: **17.09.2003**
(21) Anmeldenummer: 99926249.6
(22) Anmeldetag: 15.04.1999
(51) Int. Cl.: H05K 7/14

(54) **ELEKTRONISCHES GERÄT, INSBESONDERE INDUSTRIERECHNER**
ELECTRONIC DEVICE, ESPECIALLY AN INDUSTRIAL COMPUTER
APPAREIL ELECTRONIQUE, EN PARTICULIER CALCULATEUR INDUSTRIEL

(30) Priorität: 16.04.1998 DE 19816712
(43) Veröffentlichungstag der Anmeldung: 14.03.2001
(73) Patentinhaber: SIEMENS AKTIENGESELLSCHAFT, 80333 München (DE)
(72) Erfinder: SIEG, Wolfgang, D-76187 Karlsruhe (DE); STEIGER, Heinz-Werner, D-76676 Graben-Neudorf (DE)
(86) Internationale Anmeldenummer: DE9901138
(87) Internationale Veröffentlichungsnummer: WO99055128

(56) Entgegenhaltungen:
- EP-A- 0 505 938
- DE-U- 9 211 561
- DE-U- 29 701 401
- US-A- 5 666 264

## Beschreibung

Die Erfindung betrifft ein elektronisches Gerät, insbesondere einen Industrierechner, zum Einbau in einen Schrank oder einen geeigneten Ausschnitt einer Platte nach dem Oberbegriff des Anspruchs 1.

Ein derartiger Industrierechner zum Einbau in einen geeigneten Ausschnitt in einer Platte ist bereits aus der US-PS 5 666 264 bekannt. Häufig sind Industrierechner wie Personalcomputer aufgebaut und haben als Komponenten einen Flachbildschirm, eine Folientastatur, einen Mikroprozessor mit einem Arbeitsspeicher, einen Festplattenspeicher, ein Eingabefeld mit Mausfunktion, ein Floppylaufwerk, ein CD-ROM-Laufwerk, PCMCIA-Erweiterungen und ähnliches. Durch Einbau von Erweiterungskarten können diese Industrierechner nachträglich um zusätzliche Funktionen erweitert werden. Der in der obengenannten Druckschrift beschriebene Industrierechner kann in einen geeigneten Ausschnitt einer Platte, z. B. einer Schalttafel, eingebaut werden. Dazu wird er zunächst von der Vorderseite in den Ausschnitt der Platte eingesetzt. Ein Rand der Frontplatte, der seitlich das hintere Gehäuseteil überragt, liegt bei eingesetztem Gerät auf der Vorderseite des Ausschnittrands auf. Danach werden an den Seitenwänden des Industrierechnergehäuses Befestigungselemente eingesetzt, die den Ausschnittrand hintergreifen. In den Befestigungselementen sind Schrauben verstellbar gelagert, die gegen die Rückseite des Ausschnittrands andrehbar sind, so daß die Platte zwischen dem Rand der Frontplatte des Industrierechners und den Schrauben der Befestigungselemente eingeklemmt wird. Auf diese Weise ist die Lage des Industrierechners in dem Plattenausschnitt gesichert. Um für Wartungs- oder Änderungsarbeiten die Komponenten des elektronischen Geräts zugänglich zu machen, muß das Gehäuse geöffnet werden. Dazu wird in der US-PS 5 666 264 ein Gehäuse mit einem vorderen Gehäuseteil, das in den Ausschnitt einer Platte eingesetzt und dort befestigt wird, und einem hinteren Gehäuseteil, das die elektronischen Komponenten aufnimmt, vorgeschlagen. Die Komponenten im hinteren Gehäuseteil sind über Steckverbinder elektrisch mit den Komponenten im vorderen Gehäuseteil verbunden. Mechanisch ist das hintere Gehäuseteil am vorderen Gehäuseteil mit einem Drehgelenk schwenkbar gelagert. Sämtliche Wartungsarbeiten müssen daher hinter der Platte, in der das elektronische Gerät eingebaut ist, durchgeführt werden.

Der Erfindung liegt die Aufgabe zugrunde, ein elektronisches Gerät, insbesondere einen Industrierechner, zu schaffen, das sich durch eine einfache Konstruktion und eine bessere Zugänglichkeit für Wartungsarbeiten auszeichnet.

Zur Lösung dieser Aufgabe weist das neue elektronische Gerät der eingangs genannten Art die im kennzeichnenden Teil des Anspruchs 1 angegebenen Merkmale auf. In den Unteransprüchen sind vorteilhafte Weiterbildungen der Erfindung beschrieben.

Die Erfindung hat den Vorteil, daß die Fronteinheit, die auch als vorderes Gehäuseteil bezeichnet werden kann, mit den Anzeige- und/oder Bedienelementen von der Vorderseite zugänglich ist und zu Wartungsarbeiten abgenommen werden kann. Dabei-kann der Befestigungsrahmen mit dem hinteren Gehäuseteil, das weitere elektronische Komponenten des Geräts aufnimmt, in einem Ausschnitt einer Platte eingebaut bleiben. Durch die Zugänglichkeit von vorne werden Wartungsarbeiten erheblich vereinfacht. Ein weiterer Vorteil ist, daß Fronteinheit und Systemeinheit mit dem hinteren Gehäuseteil unabhängig voneinander vom Befestigungsrahmen abnehmbar sind. Bei einer Wartung einer Einheit kann die jeweils andere Einheit am Befestigungsrahmen verbleiben. Der Befestigungsrahmen muß nicht aus dem Schrank oder der Schalttafel ausgebaut werden.

Weiterhin ist von Vorteil, daß der Befestigungsrahmen universell für verschiedene elektronische Komponenten einsetzbar ist. Seine Konstruktion ist unabhängig von der Art der elektronischen Komponenten im hinteren Gehäuseteil und auch unabhängig von den Anzeige- und Bedienelementen in der Fronteinheit festgelegt. Diese Komponenten bestimmen lediglich den Aufbau der Systemeinheit bzw. der Fronteinheit. Die Konstruktion dieser Einheiten kann in einfacher Weise für eine Befestigung am Befestigungsrahmen ausgelegt werden. Vorteilhaft für eine hohe Montage- und Servicefreundlichkeit wirkt sich auch aus, daß der Befestigungsrahmen unabhängig von der Fronteinheit und der Systemeinheit in einem geeigneten Ausschnitt einer Platte eingebaut werden kann. Insbesondere bei größeren Geräten sind die Einzelteile leichter handhabbar als das Komplettgerät.

Mit seitlichen Laschen, in denen Öffnungen für Befestigungsschrauben angebracht sind, ist das elektronische Gerät in vorteilhafter Weise wie ein Baugruppenträger an Befestigungsschienen eines Schranks, beispielsweise eines Schranks des standardisierten 19"-Aufbausystems nach der IEC-Publikation 297-2, befestigbar. Alternativ dazu kann das elektronische Gerät in einem geeigneten Ausschnitt einer Platte, z. B. einer Schalttafel, eingesetzt werden. Dazu ist vorteilhaft ein Rand am Befestigungsrahmen angebracht, der in einer Ebene verläuft und den Plattenausschnitt seitlich überragt. Wenn der Befestigungsrahmen in den Plattenausschnitt eingesetzt ist, werden Befestigungselemente an den hinteren Seitenwänden des Befestigungsrahmens angebracht, welche den Ausschnittrand hintergreifen und gegen die Rückseite des Ausschnittrands andrückbar sind. Die Befestigungselemente sind in ähnlicher Weise ausführbar wie das in der US-PS 5 666 264 beschriebene Clip mit einer Schraube als Andrückelement.

Damit das elektronische Gerät bei Einbau in eine Schalttafel eine hohe Schutzart für Industrietauglichkeit erfüllt, beispielsweise die Schutzart IP65, weist der Rand des Befestigungsrahmens auf seiner Rückseite eine umlaufende Nut auf, in welche ein Dichtungsring zur Abdichtung des Fügespaltes zwischen Plattenoberseite der Schalttafel und Befestigungsrahmen einlegbar ist. Das Anschrauben von Befestigungsrahmen und Platte kann daher bündig bis auf Anschlag erfolgen. Die Montage wird somit stark vereinfacht, da keine besonderen Montagevorschriften, beispielsweise ein Drehmoment für Schrauben als Andrückmittel oder ein definierter Abstand zwischen Plattenoberseite und Befestigungsrahmen, einzuhalten sind.

Die Montage der Fronteinheit am Befestigungsrahmen gestaltet sich in vorteilhafter Weise besonders einfach, wenn die Fronteinheit im wesentlichen plattenförmig ausgebildet ist und der Befestigungsrahmen zur Aufnahme der Fronteinheit eine ebene Vertiefung aufweist, in welche die Fronteinheit von vorne einsetzbar ist.

In diese Vertiefung kann vor Einsetzen der Fronteinheit eine umlaufende Flachdichtung eingelegt werden. Dabei sind Abstandhalter zwischen der Vertiefung und der Fronteinheit vorgesehen, um ein Zusammendrücken der Flachdichtung auf ein vorbestimmtes Maß zu gewährleisten. Dadurch wird mit Vorteil eine gute, langzeitstabile Dichtwirkung der Flachdichtung erreicht. Zudem vereinfacht sich die Montage, da auch hier kein Drehmoment für das Anziehen von Befestigungsschrauben und kein vorgeschriebener Abstand zwischen Vertiefung und Fronteinheit eingehalten werden muß.

Ein Erfüllen der gewünschten Schutzart wird auch vorteilhaft erleichtert, wenn die Fronteinheit eine Trägerplatte aufweist, auf deren Vorderseite eine Folientastatur und eine Dichtungsklappe für von vorne zugängliche Laufwerke angebracht sind. Auf der Rückseite der Trägerplatte werden ein Tastaturcontroller sowie an Öffnungen der Trägerplatte diese abdichtend ein Flachbildschirm und/oder ein Mouse-Pad befestigt.

Die Fronteinheit ist mit einfachen Werkzeugen am Befestigungsrahmen montierbar und zu Wartungszwecken abnehmbar, wenn sie mit in ihrem Umfangsbereich angeordneten Schrauben auf dem Befestigungsrahmen lösbar zu befestigen ist.

Anhand der Zeichnungen, in denen ein Ausführungsbeispiel der Erfindung dargestellt ist, werden im folgenden die Erfindung sowie Ausgestaltungen und Vorteile näher erläutert.

Es zeigen:
- Figur: 1 ein perspektivische Darstellung eines elektronischen Geräts,
- Figur 2: eine perspektivische Darstellung eines Befestigungsrahmens in einer Ansicht von hinten und
- Figur 3: eine Explosionszeichnung eines Befestigungsrahmens mit Fronteinheit.

Gleiche Teile sind mit gleichen Bezugszeichen versehen.

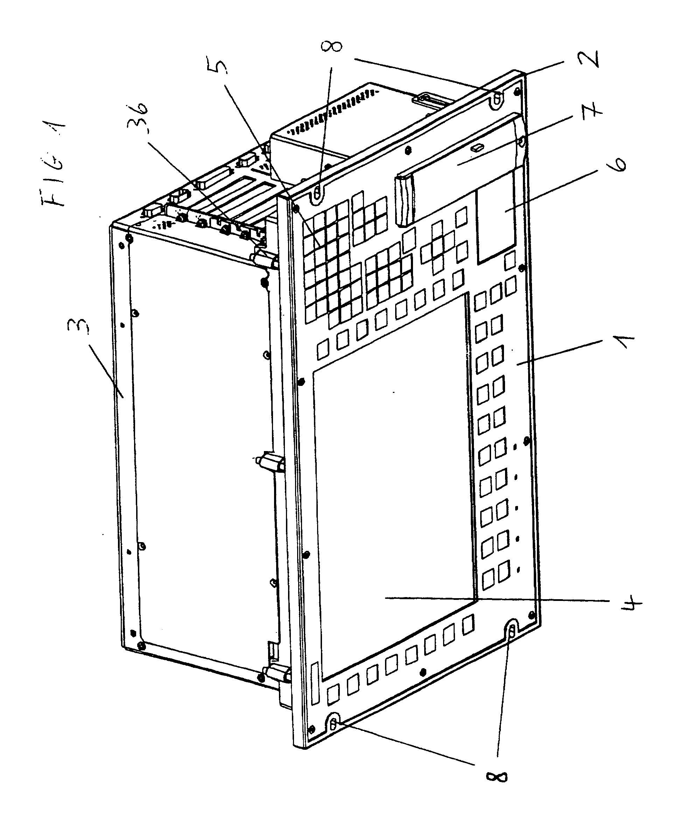

Ein elektronisches Gerät besteht gemäß Figur 1 im wesentlichen aus einer Fronteinheit 1, einem Befestigungsrahmen 2 und einer Systemeinheit 3. Die Fronteinheit 1 trägt als Anzeigeelement einen Flachbildschirm 4, der hinter einer nicht sichtbaren, eingeklebten Kontrastfilterscheibe angeordnet ist, als Bedienelemente eine Folientastatur 5 und ein Mouse-Pad 6 sowie zur Gewährleistung der gewünschten Schutzart eine Dichtungsklappe 7 für von vorne zugängliche Laufwerke, beispielsweise ein Floppy und ein CD-ROM-Laufwerk. Mit Öffnungen 8 an seitlichen Laschen des Befestigungsrahmens 2 kann das elektronische Gerät wie ein Baugruppenträger an Befestigungsschienen in einem Schrank des standardisierten 19"-Aufbausystems montiert werden. Der Befestigungsrahmen 2 ist zudem mit einem umlaufenden, seitlich überstehenden Rand versehen, mit welchem das elektronische Gerät alternativ auf den Rand eines geeigneten Ausschnitts einer Platte, z. B. zur Montage in einer Schalttafel, aufgelegt werden kann. In Figur 1 ist vom Befestigungsrahmen 2 im wesentlichen lediglich die Vorderseite des umlaufenden Randes zu sehen.

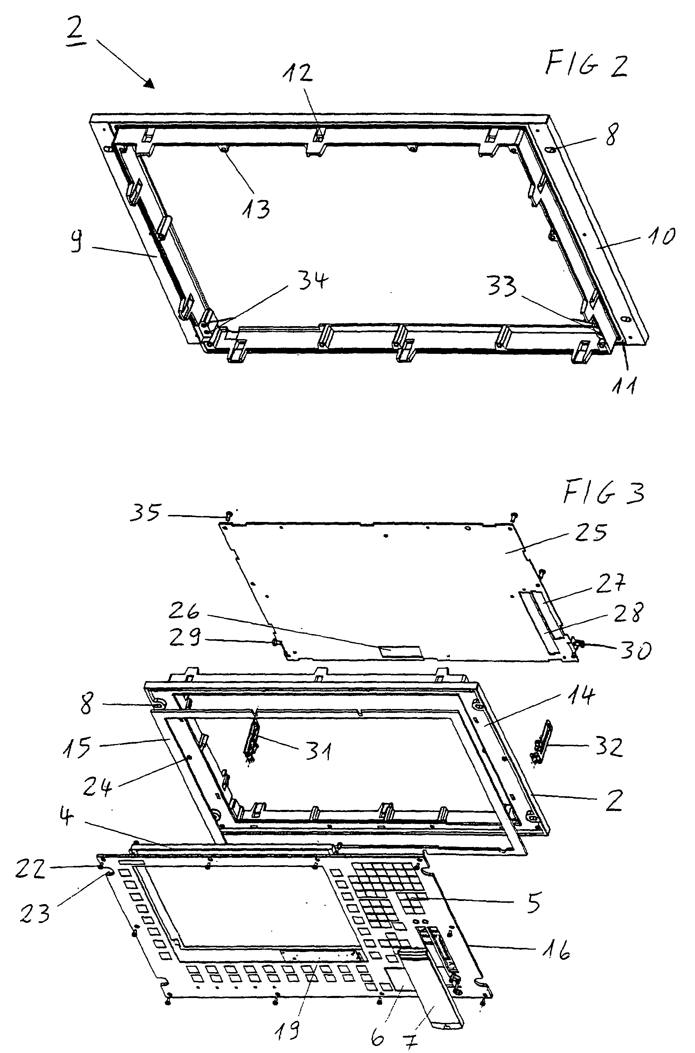

In Figur 2 wird der Aufbau des Befestigungsrahmens 2, der zur Befestigung des elektronischen Geräts wahlweise in einem Schrank oder in einer Schalttafel dient, verdeutlicht. Bei einer Befestigung an Schienen eines Schrankes wird der Befestigungsrahmen mit seitlichen Laschen 9 und 10 auf den Schienen aufgelegt und durch Schrauben, welche in Öffnungen 8 eingesetzt werden, an den Schienen gehalten. Die Laschen 9 und 10 bilden gleichzeitig auch Teile eines umlaufenden Rands, mit welchem der Befestigungsrahmen 2 bei der Montage in einem geeigneten Ausschnitt einer Platte auf der Plattenoberseite aufliegt. In dem Ausschnitt einer Platte, wie auch zwischen Schienen eines Schrankes, wird der Befestigungsrahmen 2 durch nach hinten ragende Seitenwände positioniert. In der Rückseite des Rands ist eine umlaufende Nut 11 angebracht, in welcher zum Erfüllen einer hohen Schutzart eine Dichtung eingelegt wird, die den Fügespalt zwischen der Plattenoberseite und der Rückseite des Befestigungsrahmens abdichtet. Zur Sicherung der Lage des Befestigungsrahmens 2 in dem Plattenausschnitt und zum Andrücken der Dichtung gegen die Dichtflächen werden nach dem Einsetzen des Befestigungsrahmens 2 in den Plattenausschnitt Befestigungselemente 36 (Figur 1) in Öffnungen 12 der hinteren Seitenwände des Befestigungsrahmens 2 eingesetzt. Die Befestigungselemente 36 können in bekannter Weise als Clip mit einer Schraube als Andrückelement ausgeführt werden. Beim Anziehen der Schrauben der Befestigungselemente 36, die gegen die Rückseite des Ausschnittrands drücken, wird der umlaufende Rand des Befestigungsrahmens 2 gegen die Vorderseite des Ausschnittrands gezogen und die Dichtung auf die Dichtflächen gedrückt. Dabei bildet der Rand des Befestigungsrahmens 2 einen Anschlag und begrenzt das Zusammendrücken der Dichtung. An den Seitenwänden sind zwölf Gewindebohrungen 13 angebracht, die zur Befestigung der Systemeinheit am Befestigungsrahmen 2 dienen.

Ein derartiger Befestigungsrahmen ist somit auf die zur Befestigung der Front- und der Systemeinheit erforderlichen Merkmale reduziert und kann universell für verschiedene elektronische Geräte eingesetzt werden. Beispielsweise können konstruktive Änderungen der Fronteinheit leichter vorgenommen werden, da sie sich nicht auf die Konstruktion des Befestigungsrahmens auswirken.

Gemäß Figur 3 ist der Befestigungsrahmen 2 an seiner Vorderseite mit einer Vertiefung 14 versehen, in welche eine Flachdichtung 15 zur Abdichtung gegenüber der Fronteinheit eingelegt wird. Die Fronteinheit besteht im wesentlichen aus einer Trägerplatte 16 mit dem im Bereich einer Öffnung hinter einer Kontrastfilterscheibe an die Rückseite montierten Flachbildschirm 4, der auf die Vorderseite geklebten Folientastatur 5, einem an der Rückseite befestigten Displayinverter 19, einem Tastaturcontroller (nicht dargestellt) und dem Mouse-Pad 6 sowie der Dichtungsklappe 7 für ein von vorne zugängliches Floppylaufwerk und ein CD-ROM-Laufwerk. Mit zehn Schrauben 22, die im Umfangsbereich der Trägerplatte 16 angeordnet sind, wird die Fronteinheit auf den Befestigüngsrahmen 2 montiert. Im Bereich der Öffnungen 8 für Schrankeinbau ist die Trägerplatte 16 mit Aussparungen 23 versehen. Gewindebohrungen 24 für die Schrauben 22 sind in der Vertiefung 14 des Befestigungsrahmens 2 mit einer ringförmigen Erhöhung als Abstandhalter versehen, um ein Zusammendrücken der Flachdichtung 15 auf ein vorbestimmtes Maß zu gewährleisten. Es müssen daher keine besonderen Montagevorschriften, wie z. B. ein Anzugsmoment der Schrauben 22, beachtet werden.

In dem in Figur 3 gezeigten Ausführungsbeispiel wird der Befestigungsrahmen 2 an seiner Rückseite durch eine Abdeckplatte 25 verschlossen, die aus Gründen der elektromagnetischen Verträglichkeit vorgesehen wird. Auf der Rückseite der Abdeckplatte 25 wird mit rechtwinkelig abgebogenen Laschen eine in Figur 3 nicht dargestellte Systemeinheit angeschraubt. In der Abdeckplatte 25 ist eine Öffnung 26 für ein Schnittstellenkabel zur elektrischen Verbindung der Fronteinheit mit der Systemeinheit sowie eine Öffnung 27 und eine Öffnung 28 für ein von der Vorderseite zugängliches Floppy bzw. CD-ROM-Laufwerk angebracht. Mit zwei Schrauben 29 und 30 wird die Abdeckplatte 25 in Scharnierelementen 31 bzw. 32, die auf Gewindebohrungen 33 bzw. 34 (in Figur 2) am Befestigungsrahmen 2 angeschraubt werden, eingehängt. Zusammen mit der Abdeckplatte 25 kann auf diese Weise die Systemeinheit für Serviceund Wartungsarbeiten nach Entfernen von Befestigungsschrauben 35 abgeklappt oder komplett demontiert werden. Dabei verbleibt die Fronteinheit mit dem Befestigungsrahmen 2 am jeweiligen Einbauort.

Alternativ zu dem in Figur 3 gezeigten Ausführungsbeispiel kann die Abdeckplatte 25 in ihrer Mitte mit einer großflächigen Öffnung versehen werden, durch welche im hinteren Gehäuseteil befindliche elektronische Komponenten unmittelbar nach Abnehmen der Fronteinheit von vorne für Wartungs- und Servicearbeiten zugänglich sind. In einer weiteren Alternative wird die Systemeinheit unmittelbar, d. h. ohne eine dazwischenliegende Abdeckplatte 25, an den Befestigungsrahmen 2 angeschraubt. Damit sind elektronische Komponenten der Systemeinheit durch die vollständige Öffnung des Befestigungsrahmens 2 nach der Abnahme der Fronteinheit 1 von vorne zugänglich.

## Patentansprüche

1. Elektronisches Gerät, insbesondere Industrierechner, mit einem Gehäuse, das im vorderen Gehäuseteil Anzeige- und Bedienelemente (4, 5, 6) und im hinteren Gehäuseteil weitere elektronische Komponenten des Geräts aufnimmt, **dadurch gekennzeichnet, daß** ein Befestigungsrahmen (2) zum Einbau des elektronischen Geräts in einem Schrank und/oder in einem geeigneten Ausschnitt einer Platte vorhanden ist, an welchem im eingebauten Zustand von vorne eine Fronteinheit (1) mit Anzeige- und/oder Bedienelementen (4, 5, 6) und von hinten eine Systemeinheit (3) mit weiteren elektronischen Komponenten des elektronischen Geräts befestigbar ist.

2. Elektronisches Gerät nach Anspruch 1, **dadurch gekennzeichnet, daß** zum Schrankeinbau am Befestigungsrahmen (2) seitliche Laschen (9, 10) mit Öffnungen (8) angebracht sind, so daß das elektronische Gerät wie ein Baugruppenträger an Befestigungsschienen eines Einbauschrankes befestigbar ist.

3. Elektronisches Gerät nach Anspruch 1 oder 2, **dadurch gekennzeichnet, daß** zum Einbau in einem geeigneten Ausschnitt einer Platte, z. B. einer Schalttafel, am Befestigungsrahmen (2) ein Rand angebracht ist, der in einer Ebene verläuft und den Plattenausschnitt seitlich überragt, daß zumindest ein Befestigungselement (36) vorgesehen ist, mit welchem, wenn der Befestigungsrahmen (2) in einen geeigneten Plattenausschnitt eingesetzt ist, der Ausschnittrand hintergreifbar ist und welches gegen die Rückseite des Ausschnittrands andrückbar ist.

4. Elektronisches Gerät nach Anspruch 3, **dadurch gekennzeichnet, daß** der Rand des Befestigungsrahmens (2) auf seiner Rückseite eine umlaufende Nut (11) aufweist, in welche ein Dichtungsring zur Abdichtung des Fügespaltes zwischen Plattenoberseite und Befestigungsrahmen (2) einlegbar ist.

5. Elektronisches Gerät nach einem der vorhergehenden Ansprüche, **dadurch gekennzeichnet, daß** die Fronteinheit (1) im wesentlichen plattenförmig ausgebildet ist, und daß der Befestigungsrahmen (2) zur Aufnahme der Fronteinheit (1) eine ebene Vertiefung (14) aufweist, in welche die Fronteinheit (1) von vorne einsetzbar ist.

6. Elektronisches Gerät nach Anspruch 5, **dadurch gekennzeichnet, daß** in die Vertiefung (14) eine umlaufende Flachdichtung (15) einlegbar ist, und daß Abstandhalter zwischen der Vertiefung (14) und der Fronteinheit (1) vorgesehen sind, um bei der Montage ein Zusammendrücken der Flachdichtung (15) auf ein vorbestimmtes Maß zu gewährleisten.

7. Elektronisches Gerät nach einem der vorhergehenden Ansprüche, **dadurch gekennzeichnet, daß** die Fronteinheit (1) eine Trägerplatte (16) aufweist, auf deren Vorderseite eine Folientastatur (5) und eine Dichtungsklappe (7) für von vorne zugängliche Laufwerke und auf deren Rückseite ein Tastaturcontroller, ein Displayinverter (19), ein Flachbildschirm (4) und/oder ein Mouse-Pad (6) angebracht sind.

8. Elektronisches Gerät nach einem der vorhergehenden Ansprüche, **dadurch gekennzeichnet, daß** die Fronteinheit (1) mit in ihrem Umfangsbereich angeordneten Schrauben (22) auf dem Befestigungsrahmen (2) lösbar zu befestigen ist.

## Claims

1. Electronic appliance, in particular industrial computer, having a housing that receives display elements and operating elements (4, 5, 6) in the front housing part and further electronic components of the appliance in the rear housing part, **characterized in that** a fixing frame (2) is present for installing the electronic appliance in a cabinet and/or in a suitable cutout in a panel, to which frame, in the installed state, a front unit (1) with display elements and/or operating elements (4, 5, 6) can be fixed from the front and a system unit (3) with further electronic components of the electronic appliance can be fixed from the rear.

2. Electronic appliance according to Claim 1, **characterized in that** lateral strips (9, 10) having openings (8) are provided on the fixing frame (2) for cabinet installation so that the electronic appliance can be fixed like a subrack on fixing rails of an installation cabinet.

3. Electronic appliance according to Claim 1 or 2, **characterized in that**, for installation in a suitable cutout in a panel, for example a control panel, a rim that extends in one plane and projects laterally beyond the panel cutout is provided on the fixing frame (2) and **in that** at least one fixing element (36) is provided with which, if the fixing frame (2) is inserted into a suitable panel cutout, the cutout rim can be engaged behind and which can be pressed against the back of the cutout rim.

4. Electronic appliance according to Claim 3, **characterized in that** the rim of the fixing frame (2) has, on its back, a circumferential groove (11) in which a sealing ring can be laid to seal the joint gap between the panel top and the fixing frame (2).

5. Electronic appliance according to any of the preceding claims, **characterized in that** the front unit (1) is essentially panel-shaped and **in that** the fixing frame (2) for receiving the front unit (1) has a flat recess (14) into which the front unit (1) can be inserted from the front.

6. Electronic appliance according to Claim 5, **characterized in that** a circumferential flat seal (15) can be laid in the recess (14) and **in that** spacers are provided between the recess (14) and the front unit (1) in order to ensure a compression of the flat seal (15) to a predetermined extent during assembly.

7. Electronic appliance according to any of the preceding claims, **characterized in that** the front unit (1) has a support plate (16) on whose front a membrane keyboard (5) and a sealing flap (7) are provided for drives accessible from the front and, on whose back, a keyboard controller, a display inverter (19), a flat viewing screen (4) and/or a mouse pad (6) are provided.

8. Electronic appliance according to any of the preceding claims, **characterized in that** the front unit (1) can be detachably fixed to the fixing frame (2) with screws (22) disposed in its peripheral region.

## Revendications

1. Appareil électronique, notamment calculateur industriel, comportant un boîtier qui loge des éléments d'affichage et de commande (4, 5, 6) dans la partie avant et d'autres composants électroniques de l'appareil dans la partie arrière, **caractérisé par le fait qu'**un cadre de fixation (2) est prévu pour le montage de l'appareil électronique dans une armoire et/ou dans une découpe appropriée d'une plaque et que, à l'état monté, une unité frontale (1) avec éléments d'affichage et/ou de commande (4, 5, 6) peut être fixée par l'avant à ce cadre de fixation et une unité de système (3) avec d'autres composants électroniques de l'appareil électronique peut être fixée par l'arrière à ce cadre de fixation.

2. Appareil électronique selon la revendication 1, **caractérisé par le fait que**, pour le montage dans une armoire, il est prévu sur le cadre de fixation (2) des éclisses latérales (9, 10) avec des ouvertures (8) de telle sorte que l'appareil électronique peut être fixé comme un châssis de modules à des rails de fixation d'une armoire.

3. Appareil électronique selon la revendication 1 ou 2, **caractérisé par le fait que**, pour le montage dans une découpe appropriée d'une plaque, par exemple d'un panneau de commande, il est prévu sur le cadre de fixation (2) un bord qui s'étend dans un plan et qui dépasse latéralement de la découpe de plaque, et il est prévu au moins un élément de fixation (36) avec lequel le bord de découpe peut être pris par derrière, lorsque le cadre de fixation (2) est placé dans une découpe de plaque appropriée, et qui peut être poussé contre le côté arrière du bord de découpe.

4. Appareil électronique selon la revendication 3, **caractérisé par le fait que** le bord du cadre de fixation (2) comporte sur son côté arrière une rainure (11) qui fait tout le tour et dans laquelle un joint d'étanchéité peut être posé pour l'étanchéité de la fente de jointure entre le dessus de plaque et le cadre de fixation (2).

5. Appareil électronique selon l'une des revendications précédentes, **caractérisé par le fait que** l'unité frontale (1) est conçue globalement en forme de plaque et que le cadre de fixation (2) comporte pour le logement de l'unité frontale (1) une cavité plane (14) dans laquelle l'unité frontale (1) peut être posée par l'avant.

6. Appareil électronique selon la revendication 5, **caractérisé par le fait qu'**un joint plat (15) qui fait tout le tour peut être posé dans la cavité (14) et que des dispositifs d'écartement sont prévus entre la cavité (14) et l'unité frontale (1) pour garantir lors du montage une compression du joint plat (15) sur une distance prédéterminée.

7. Appareil électronique selon l'une des revendications précédentes, **caractérisé par le fait que** l'unité frontale (1) comporte une plaque de support (16) sur le côté avant de laquelle se trouvent un clavier à effleurement (5) et un volet d'étanchéité (7) pour des lecteurs accessibles par l'avant et sur le côté arrière de laquelle se trouvent un contrôleur de clavier, un inverseur d'affichage (19), un écran plat (4) et/ou une souris (6).

8. Appareil électronique selon l'une des revendications précédentes, **caractérisé par le fait que** l'unité frontale (1) est à fixer de manière amovible au cadre de fixation (2) avec des vis (22) disposées sur sa zone périphérique.
